# EUROPEAN PATENT SPECIFICATION

(11) **EP 1 465 334 B1**
(45) Date of publication and mention of the grant of the patent: **14.09.2011**
(21) Application number: 03007555.0
(22) Date of filing: 01.04.2003
(51) Int. Cl.: H03D 7/14

(54) **Passive Mixer**
Passiver Mischer
Mélangeur passif

(43) Date of publication of application: 06.10.2004
(73) Proprietor: Telefonaktiebolaget L M Ericsson (publ), 164 83 Stockholm (SE)
(72) Inventor: Tillman, Fredrik, 226 49 Lund (SE); Sjöland, Henrik, 246 51 Löddeköpinge (SE)
(74) Representative: Åkerman, Mårten Lennart

(56) References cited:
- EP-A- 1 119 102
- US-A- 3 694 756
- US-A- 5 060 298
- US-A- 5 606 738
- US-B1- 6 400 777

## Description

### Technical Field of the Invention

The present invention relates to a passive mixer, and more particularly to a passive mixer having a configuration for improved linearity.

### Description of Related Art

A mixer for converting a signal having a first frequency, such as radio frequency (RF), to a signal having a second frequency, such as an intermediary frequency (IF), is provided in a wide variety of implementations, such as in radio transceiver front-ends. Bluetooth® is a communication standard where the major goal has been to remove cable connections between electrical equipment. One area, where Bluetooth® is of particular interest, is communication involving portable equipment, such as mobile terminals. The terminals may also be adapted to communicate according to e.g. a telecommunication technology, such as GSM, UMTS, cdma2000, PCS, DCS etc. A mixer may be necessary for the radio transceiver front-end of the Bluetooth® radio and the telecommunication radio.

In portable communication equipment, low power solutions for all electronic components are important. Thus, the tendency in integrated circuit design is to apply low supply voltage for e.g. the mixer. Also, it is often required that the implementation of the mixer is cheap. MOS (Metal Oxide Semiconductor) technology offers a solution, with which is possible to implement fully integrated mixers. However, it is essential to find circuit architectures capable of high performance at supply voltages at or below 2V.

Frequency translation using mixing means can be provided in either the current or the voltage domain using a non-linear transfer. However, mixing can also be achieved by applying multiplication in the time domain. In such a case the mixer can be viewed as a two-state machine, wherein the mixer should be as linear as possible in each state. This type of mixer represents a linear time-variant system.

The switching from a conducting to a non-conducting state of a mixing means can be provided in either the current or the voltage domain. In case of bipolar technology, the current switching is superior. The MOSFET (Metal Oxide Semiconductor Field Effect Transistor) transistor offers true voltage switch characteristics. Thus, it is feasible to perform the switching in the voltage domain for the MOSFET transistor.

Integrated analog circuits will in the future be driven by lower supply voltages than today due to the CMOS (Complementary MOS) technology scaling and the system-on-chip trend, wherein a radio transceiver is provided on a single chip. This trend will enforce shared technology between the digital and analog domain, making low voltage implementations necessary. In the receiver front-end, one major bottleneck is the linearity of the down-converting mixer. This is particularly the case for low supply voltages, even if a suitable topology is used, such as the passive CMOS mixer.

In operation, a MOSFET transistor is conducting when the gate-source voltage V_{gs} becomes larger than the threshold voltage V_{T}. A transistor receiving a RF signal on either its drain or source terminal may provide a varying source, or drain, node potential. Said potential will vary in dependence of a signal provided on the gate input terminal, which often times is a local oscillator (LO) signal. Also, a RF leakage may occur. The critical signal is the intermediary frequency (IF) signal provided on the source/drain terminal, which will modulate the on-time of the switch and cause non-linearity. A MOSFET transistor switch operating in either the off state or as a triode (on state), will be controlled not only by the gate voltage, but also by the source voltage. Consequently the IF output signal provided at the source/drain will modulate the switch duty cycle and generate intermodulation products. This is especially severe for low supply voltages, which limit the achievable LO amplitude.

A common way to reduce the switch non-linearity is to use a complementary switch known as a transmission gate. However, such a switch will increase the load capacitance of a low noise amplifier (LNA), which often precedes the mixer of a receiver, resulting in lower conversion gain and smaller bandwidth. Furthermore, if the mixer is balanced, the complementary switch will only effect even order non-linearity.

US 5,606,738 discloses a frequency conversion circuit having at least one transistor with an input terminal and an output terminal. A frequency signal to be converted or a local oscillator (LO) signal is input to the input terminal, and a converted frequency signal is output from the output terminal. A linear feedback circuit allowing at least a radio frequency (RF) signal and the LO signal to feed back is directly connected across the input and output terminals.

### Summary of the Invention

One object of the present invention is to provide a mixer having improved linearity compared to equivalent mixers known in the art. More specifically, it is an object of the invention to provide a mixer having improved linearity at low supply voltage, which may be implemented as an integrated circuit using on chip implementation technology, such as MOS (Metal Oxide Semiconductor) or JFET (Junction Field Effect Transistor) technology.

According to one aspect of the invention, the above objects are achieved by a passive mixer for converting a first signal having a first frequency to a signal having a second frequency according to Claim 1.

The mixing means may be a voltage controlled switch, such as a FET transistor switch having either its drain or source operatively connected to the first terminal, its gate operatively connected to the second terminal, and either its source or drain operatively connected to the third terminal. The FET transistor may be a NMOS transistor having superior switch performance compared to a PMOS transistor.

The mixer may be provided as a balanced or non-balanced mixer. A balanced mixer may comprise four mixing means, wherein each of said means comprises a bootstrap circuit.

According to another aspect of the invention, the mixer is used in electronic equipment, such as a portable communication equipment. Portable equipment comprises, but is not limited to, a mobile radio terminal, a mobile telephone, a pager, or a communicator, i.e. a personal digital assistant, a smartphone, etc. The mixer may also be used in electronic equipment for communication in a wireless local area network, such as equipment adapted for short-range supplementary communication, e.g. according to Bluetooth® technology.

An advantage of the present invention is that no DC current flows through the mixing means. The absence of any DC current will reduce the 1/f noise of the mixer. The topology of the invention combined with MOS technology has the advantage that it is suitable for low voltage implementations, such as approximately 2V and below, as a MOS circuit does not use stacked transistors. As the supply voltage will be further decreased in the future the invention will become even more important. Furthermore, the invention improves the linearity compared to mixers known in the art without sacrificing other important parameters, such as noise performance and conversion gain.

Further preferred embodiments of the invention are defined in the dependent claims.

It should be emphasized that the term "comprises/comprising" when used in this specification is taken to specify the presence of stated features, integers, steps or components but does not preclude the presence or addition of one or more other features, integers, steps, components or groups thereof.

### Brief Description of the Drawings

Further objects, features, and advantages of the invention will appear from the following description of several embodiments of the invention, wherein various aspects of the invention will be described in more detail with reference to the accompanying drawings, in which:
Fig. 1 is a front view of a mobile telephone and the environment in which it may operate;
Fig. 2 is a block diagram of the mixer according to the invention;
Fig. 3 is a block diagram of a first embodiment of the mixer according to the invention;
Fig. 4 is a block diagram of a second embodiment of the mixer according to the invention; and
Fig. 5 is a diagram illustrating measurement results of the mixer of Fig. 4.

### Detailed Description of Embodiments

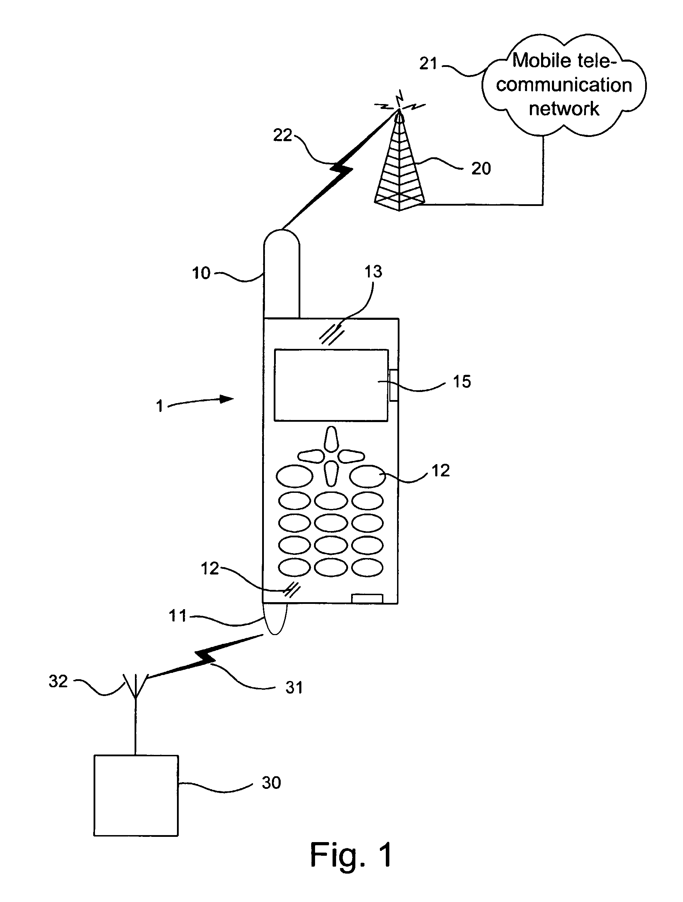

Fig. 1 illustrates a mobile telephone 1 as one exemplifying electronic equipment, in which the mixer according to the present invention may be provided, and a possible environment in which it operates. The invention is not limited to a mobile telephone 1 but can be provided in a wide variety of electronic equipment wherein a mixer is required for converting a first signal having a first frequency, such as an intermediary frequency (IF) or a radio frequency (RF), to a second signal having a second frequency, such as a RF or a an IF frequency, by means of a third signal having a third frequency generated by e.g. a local oscillator (LO). The mobile telephone 1 comprises a first antenna 10 and a second auxiliary antenna 11. A microphone 12, a loudspeaker 13, a keypad 14, and a display 15 provide a man-machine interface for operating the mobile telephone 1.

The mobile telephone may in operation be connected to a radio station 20 (base station) of a mobile communication network 21, such as a GSM, UMTS, PCS, and/or DCS network, via a first radio link 22 by means of the first antenna 10. Furthermore, the mobile telephone 1 may in operation establish a second wireless link to a peripheral device 30 via second wireless link 31 by means of the auxiliary antenna 11. The second link 31 is e.g. a Bluetooth® link, which is established in the 2.4 (2.400-2.4835) GHz frequency range. To establish the wireless links 22, 31, the mobile telephone 1 comprises radio resources, which are adapted according to the relevant technologies. Thus, the mobile telephone 1 comprises one radio access means, such as a transceiver, for communicating with the base station 20, and one radio access means for communicating with the peripheral device 30.

The peripheral device 30 may be any device having wireless communicating capabilities, such as according to Bluetooth® technology or any other wireless local area network (WLAN) technology. It comprises an antenna 32 for exchanging signals over the second link 31, and a transceiver (not shown) adapted according to the communication technology that the peripheral device 30 uses. The device may be a wireless headset, a remote server, a fax machine, a vending machine, a printer etc. A wide variety of electronic equipment may have such communication capabilities and have a need for wirelessly transferring of data.

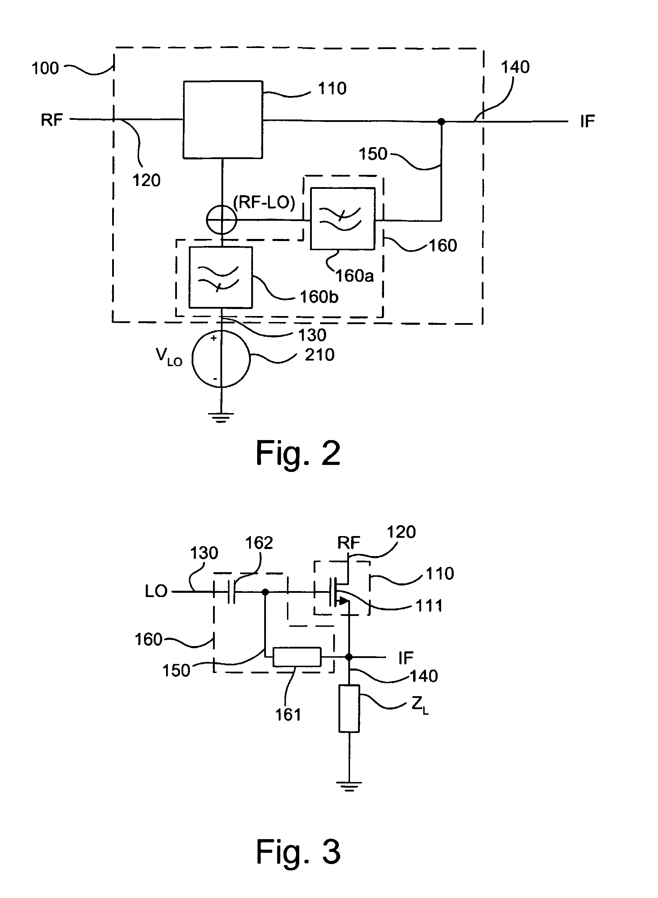

Fig. 2 is a block diagram of a passive mixer 100 according to the invention. The mixer 100 is a frequency-translating mixer for down-converting radio frequency (RF) signal to an intermediary frequency (IF) signal. Alternatively, the mixer 100 up-converts an IF signal to an RF signal. The mixer 100 comprises a mixing means 110, a first terminal 120, a second terminal 130, and a third terminal 140. At the first terminal 120 will a RF signal either be an input signal (in a receiver mixer) or an output signal (in a transmitter mixer). At the third terminal 140 there will be provided an IF signal, which can either be an input signal (in a transmitter mixer) or an output signal (in a receiver mixer). At the second terminal 130 there will be provided a local oscillator (LO) signal, which has a frequency for converting either the IF signal or the RF signal.

The second terminal 130 is operatively connected to a voltage supply 210 being a local oscillator (LO), which provides a signal having a third frequency suitable for providing the RF or IF signal. The voltage supply 210 is referenced to grounding means, such as the substrate on which it is provided. A high pass filter component 160b may be provided in the signal path between the second terminal 130 and the mixing means 110, said high pass filter component passes the high frequency signal from the voltage supply 210 to the mixing means and prevents low frequency signals from the third terminal 140 to enter the voltage supply 210.

The mixer 100 further comprises a feedback circuit 150 connected to the third terminal 140 to the connection between the high pass filter component 160b and the mixing means 110. The feedback circuit 150 may comprise a feedback filter 160 (low-pass filter) for allowing low-frequency signals from the third terminal to be fed back. Said feedback filter 160 comprises a low-pass filter component 160a, which passes low-frequency signals from the third terminal to the mixing means 110, and the high-pass filter component 160b for passing high frequency signals from the voltage supply 210.

Fig. 3 illustrates one embodiment of the mixing means 110 and the feedback filter 160 for a receiver or a transmitter radio front-end. The mixing means 110 comprises a FET transistor 111, such as a MOSFET, having its drain connected to the first terminal 120, its gate operatively connected to the second terminal 130 via a capacitor 162, and its source connected to the third terminal 140. As the MOSFET transistor is symmetrical, the drain and source, whenever mentioned in this description, may be interchanged.

The mixing means 110 provides a voltage switch for providing mixing of the RF signal and the LO signal, or mixing of the IF signal and the LO signal. The MOS transistor 111 has true voltage switch characteristics. Therefore, it is possible to provide switching in the voltage domain. This makes it possible to reduce the DC current flow through the transistor 111, and thereby avoid the 1/f noise which would be a problem especially for direct conversion and low IF-receiver characteristics.

In the embodiment of Fig. 3 the transistor 111 is provided as a field effect transistor (FET), such as a NMOS transistor. The NMOS transistor has better switch performance than the PMOS transistor due to the better mobility of electrons than holes. However, the transistor may alternatively be provided using a PMOS transistor. Other voltage controlled switches, such as the junction field effect transistor (JFET) may still alternatively be utilized as the mixing means.

To take care of the non-linearity problem of the prior art, the feedback circuit 150 will cause the gate voltage to follow the low frequency output potential variations. The feedback filter 160 is adapted to pass a low-frequency difference component (RF-LO) of the IF signal, and filter out a high frequency addition component (RF+LO) of said IF signal. The low-frequency component will be fed to the gate of the transistor 111, which will be modulated by the low frequency component of the IF signal together with the LO signal. By providing the bootstrapping feedback circuit 150, the transistor will be independent of the high-frequency component of the IF signal, which makes the mixer 100 more linear. The switching instant of the transistor 111, i.e. when the transistor switches from a non-conducting to a conducting state, is dependent on the gate-source voltage V_{gs}. If the IF signal at the source electrode Vₛ varies, V_{gs} will vary. The feedback circuit 150 makes the overdrive voltage, which is dependent on V_{gs}, independent of the IF signal. The feedback filter 160 will also prevent LO to IF leakage.

The feedback filter 160 may be provided in a number of ways. In Fig. 3, a first order filter is provided using a resistor 161 and a capacitor 162. The capacitor 162 is connected between the second input terminal 130 and the transistor gate. The resistor 161 is connected between the third terminal 140 and the connection between the capacitor 162 and the transistor gate. Alternative filter solutions may be higher order passive filters or active filters.

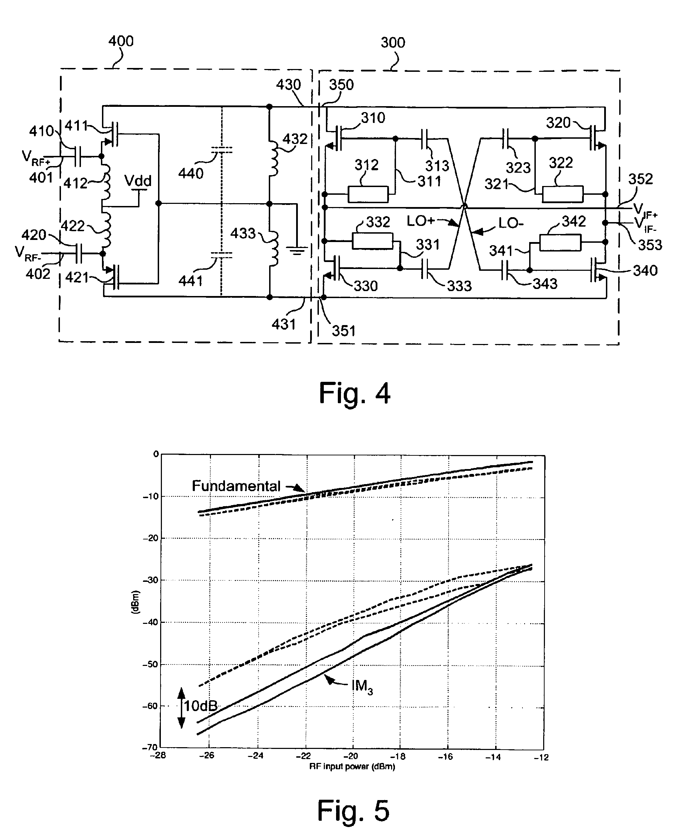

Fig. 4 illustrates an embodiment wherein the present invention comprises a passive balanced mixer 300 for down-converting an IF signal having an even number of transistors. The mixer 300 is connected to a low noise amplifier (LNA) stage 400 providing the RF signal. In this implementation, the RF signal and the IF signal are differential signals. However, the IF and RF signals may alternatively be single ended. The balanced mixer is desired for on chip implementation as it provides less disturbance (noise) and cancellation of even and odd non-linearity. The balanced mixer 300 may also be implemented in a transmitter for up-converting an IF signal. The mixer 300 comprises in this embodiment four mixing means 310, 320, 330, 340. Said mixing means have essentially the same configuration as the mixing means disclosed in Fig. 3. Consequently, each transistor 310, 320, 330, 340 is provided as a FET transistor. The feedback circuits 311, 321, 331, 341 are connected between source and gate of the first and second transistors 310, 320, and between gate and drain of the third and fourth transistors 330, 340, respectively. Also, filters are provided by resistors 312, 322, 332, 342 and capacitors 313, 323, 333, 343. The balanced mixer 300 comprises first and second terminals 350, 351 for receiving (or providing in the case of a transmitter mixer) an RF signal. The capacitor 313 connected to the first transistor 310 is also connected to the capacitor 343 connected to the fourth transistor 340. At the connection between said capacitors 313, 343 a negative LO or translation signal, LO⁻, is provided, which has a required frequency for frequency translating an input RF signal. Thus the input terminals of the filter capacitors 313, 323, 333, 343 correspond to the second terminal 130 of Fig. 3. The capacitor 323 connected to the second transistor 320 is also connected to the capacitor 333 connected to the third transistor 330. The source of the first transistor 310 is connected to the drain of the third transistor 330. The source of the second transistor 320 is connected to the drain of the fourth transistor 340. At the connection between said capacitors 323, 333, there is provided a positive LO or translation signal, LO⁺, which has a required frequency for frequency translating a RF signal. A positive output terminal 352 is connected to the source of the first transistor 310 and the drain of the third transistor 330, for providing a positive IF signal, V_{IF+}. A negative output terminal 353 is connected to the source of the second transistor 320 and the drain of the fourth transistor 340, for providing a negative IF signal, V_{IF-}. The output terminals 352, 353 will be input terminals when the mixer is provided in a transmitter.

The LNA 400 comprises first and second input terminals 401, 402 for receiving a differential input RF signal V_{RF+} and V_{RF-}, respectively. The first input terminal 401 is connected to a capacitor 410 being connected to the source of a first LNA transistor 411 providing a first amplifying means. Said source is also operatively referenced to supply, Vdd, via an inductor 412. The gate of the first LNA transistor 411 is referenced to grounding means. The second input terminal 402 is connected to a capacitor 420 being connected to the source of a second LNA transistor 421 providing a second amplifying means. Said source is also operatively referenced to supply, Vdd, via a second inductor 422. The gate of the second LNA transistor 421 is referenced to grounding means. The drain of the first LNA transistor 411 is connected to a positive output terminal 430, and the drain of the second LNA transistor 421 is connected to a negative output terminal 431. Third and fourth inductors 432, 433 are provided between grounding means and the LNA output terminals 430, 431, respectively. The output terminals 430, and 431 of the LNA 400 are connected to the input terminals 350, and 351 of the mixer 300, respectively.

The LNA 400 is arranged as a common gate configuration, which provides a broadband matching for the differential input. A common gate configuration is used to achieve a 50Ω input matching. The input resistance is approximately 1/gₘ, where gₘ is the transconductance of the LNA transistors 411, 421. In the embodiment of Fig. 4, PMOS transistors are chosen as the LNA transistors 411, 421 for biasing reasons. Since the LO signal provided by the mixing means 300 shown in Fig. 4 will have a maximum voltage swing from ground to 2V, for a voltage supply of 1V, it is best for the NMOS transistors 310, 320, 330, 340 of the mixing means 300 to have a DC output level equal to zero, as set out above. This will maximize the gate-source voltage, which is important for the mixer noise and linearity. The LNA transistors 411, 421 are biased by the inductors 412, 422, which maximizes the signal level that can be handled at the output, resulting in improved linearity. Due to the inductors 432, 433 at the output terminals 430, 431, these nodes will be able to reach negative voltages down to the knee voltage of the drain diodes of the transistors 310, 320, 330, 340 of the mixing means 300. Parallel with the third and fourth inductors 432, 433 there will be parasitic capacitances 440, 441 present, as is illustrated with dotted lines.

In one exemplifying embodiment of the invention, the mixing means 300 and LNA 400 are designed for a fully integrated 1V 0.25 µm CMOS 2.4 GHz Bluetooth® radio front-end for low IF. The sizing of the components of the mixing means 300 are:

| | |
|---|---|
| Resistors | 1kΩ; |
| Capacitors | 1pF; and |
| transistors | width 50 µm, |
| | length 0.25 µm. |

The sizing of the components of the LNA 400 are:

| | |
|---|---|
| capacitors | 1pF; |
| bias inductors | 7nH; |
| output inductors | 6nH; |
| parasitic capacitance | 100fF; and |
| transistors | length 350 µm |
| | width 0.25 µm. |

The measurement results of the circuit of Fig. 4 are depicted in Fig. 5. The linearity was measured with a two-tone test with a LO frequency equal to 2.467 GHz, in IF fundamental at 7 MHz and an IM₃ (third-order intermodulation product) at 6MHz. The results are plotted in Fig. 5, wherein the measurement results of the inventive mixer are shown with a solid line and the results of an equivalent mixer without bootstrapping are shown with a dashed line. As can be seen from the graph, the front-end using bootstrapping according to the invention has an IM₃ lowered by about 10dB, which results in an IIP3 (third order input intercept point) improved by 5dB. At the same time, the fundamental IF of the front end using bootstrapping is slightly better than for the front-end without.

The exemplifying sizing of the mixer 300 and LNA 400 of Fig. 4 should not be taken as limiting the scope of the invention. The invention may be provided in a wide variety of implementations, wherein the sizing of the circuit has to be tested and evaluated in each particular case.

In the above, reference has been made to RF and IF frequencies. However, the invention is not limited to RF and IF frequencies, but can be used in any configuration wherein a first signal having a first frequency is to be converted to a second signal having a second frequency.

The present invention has been described above with reference to specific embodiments. However, other embodiments than the above described are equally possible within the scope of the invention. The different features of the invention may be combined in other combinations than those described. The invention is only limited by the appended patent claims.

## Claims

1. A passive mixer (100; 300) for converting a first signal having a first frequency to a second signal having a second frequency, comprising:
mixing means (110; 310, 320, 330, 340), a first terminal (120), a second terminal (130) and a third terminal (140), for providing the second signal by mixing a third signal having a third frequency provided as input at said second terminal, the first signal being provided as input at either the first or the third terminal; wherein:
the first terminal (120) is connected to a first mixing means terminal of the mixing means (110);
the second terminal (130) is operatively connected to a second mixing means terminal of the mixing means;
the third terminal (140) is operatively connected to a third mixing means terminal of the mixing means; and by
a low pass filter (160) operatively connected to said third (140) terminal at one end and to said second terminal (130) at another end thereof, such that
in a down-conversion alternative the first signal is provided as input to the first terminal (120) and the second signal is provided as output from the third terminal (140); and
in an up-conversion alternative the first signal is provided as input to the third terminal (140) and the second signal is provided as output from the first terminal (120).

2. The mixer according to claim 1, **characterized in that**, in the down-conversion alternative,
the second signal is provided at the third terminal (140);
the first signal is provided as input at the first terminal (120); and
the low pass filter (160) is comprised in a feedback circuit (150; 311, 321, 331, 341) operatively connected to said third (140) and said second terminal (130).

3. The mixer according to claim 2, **characterized in that** the feedback circuit (150; 311, 321, 331, 341) is a bootstrap circuit.

4. The mixer according to any of the previous claims, **characterized in that** the filter (160) comprises a capacitor (162, 313, 323, 333,343) connected between said second terminal and said mixing means, and a resistor (161; 312, 322, 332, 342) connected between said third terminal and the connection between said capacitor and said mixing means.

5. The mixer according to claim 1, **characterized in that**, in the up-conversion alternative,
the second signal is provided at the first terminal (120); and
the first signal is provided as input at the third terminal (140).

6. The mixer according to any of the previous claims, **characterized in that** said mixing means is a voltage controlled switch.

7. The mixer according to any of the previous claims, **characterized in that** said mixing means comprises a FET transistor switch (111; 310, 320, 330, 340) having either its drain or source operatively connected to said first terminal, its gate operatively connected to said second terminal, and either its source or drain operatively connected to said third terminal.

8. The mixer according to claim 7, **characterized in that** said FET transistor is a NMOS transistor.

9. The mixer according to any of the previous claims, **characterized in that** the mixer is a balanced mixer comprising an even number of mixing means.

10. Use of the mixer according to any of the claims 1-9 in electronic equipment (1, 30).

11. Use according to claim 10, wherein the electronic equipment is a portable communication equipment (1, 30) having a supply voltage of less than 2V.

12. Use according to claim 10 or 11, wherein the electronic equipment is a mobile radio terminal, a mobile telephone (1), a pager, or a communicator.

13. Use according to claim 10, wherein the electronic equipment is adapted to operate in a wireless local area network.

14. Use according to claim 10 or 11, wherein the mixer is used in a communication equipment (30) adapted to provide short-range supplementary communication according to Bleutooth® technology.

15. Apparatus comprising the mixer (300) according to any of the claims 1-9, said mixer is connected to a low noise amplifier (LNA) (400) comprising:
a first input terminal (401) connected to a first capacitor (410) being connected to a first amplifying means (411), said first amplifying means is connected to a first output terminal (430) and to voltage supply via a first inductor (412);
a second input terminal (402) connected to a second capacitor (420) being connected to a second amplifying means (421), said second amplifying means is connected to a second output terminal (431) and to voltage supply via an second inductor (422); and
wherein the first and second amplifying means (411, 421) are referenced to grounding means, and the first and second output terminals (430, 431) are referenced to said grounding means via third and fourth inductors (432, 433).

## Patentansprüche

1. Passiver Mischer (100; 300) zum Umformen eines ersten Signals mit einer ersten Frequenz in ein zweites Signal mit einer zweiten Frequenz, umfassend:
Mischmittel (110; 310, 320, 330, 340), einen ersten Anschluss (120), einen zweiten Anschluss (130) und einen dritten Anschluss (140) zum Bereitstellen des zweiten Signals durch Mischen eines dritten Signals mit einer dritten Frequenz, das als Eingabe am zweiten Anschluss bereitgestellt wird, wobei das erste Signal entweder am ersten oder dem dritten Anschluss als Eingabe bereitgestellt wird; wobei
der erste Anschluss (120) mit einem ersten Mischmittelanschluss der Mischmittel (110) verbunden ist;
der zweite Anschluss (130) betrieblich mit einem zweiten Mischmittelanschluss der Mischmittel verbunden ist;
der dritte Anschluss (140) betrieblich mit einem dritten Mischmittelanschluss der Mischmittel verbunden ist; und durch
ein Tiefpassfilter (160) betrieblich mit dem dritten (140) Anschluss an einem Ende und mit dem zweiten (130) Anschluss an einem anderen Ende davon verbunden ist, derart dass
in einer Abwärtsumformungsalternative das erste Signal als Eingabe in den ersten Anschluss (120) bereitgestellt wird, und das zweite Signal als Ausgabe aus dem dritten Anschluss (140) bereitgestellt wird; und
in einer Aufwärtsumformungsalternative das erste Signal als Eingabe in den dritten Anschluss (140) bereitgestellt wird, und das zweite Signal als Ausgabe aus dem ersten Anschluss (120) bereitgestellt wird.

2. Mischer nach Anspruch 1, **dadurch gekennzeichnet, dass** in der Abwärtsumformungsalternative
das zweite Signal am dritten Anschluss (140) bereitgestellt wird;
das erste Signal als Eingabe am ersten Anschluss (120) bereitgestellt wird;
das Tiefpassfilter (160) in einer Rückkopplungsschaltung (150; 311, 321, 331, 341) enthalten ist, die betrieblich mit dem dritten (140) und dem zweiten Anschluss (130) verbunden ist.

3. Mischer nach Anspruch 2, **dadurch gekennzeichnet, dass** die Rückkopplungsschaltung (150; 311, 321, 331, 341) eine Bootstrap-Schaltung ist.

4. Mischer nach einem der vorhergehenden Ansprüche, **dadurch gekennzeichnet, dass** das Filter (160) einen Kondensator (162, 313, 323, 333, 343), der zwischen den zweiten Anschluss und die Mischmittel geschaltet ist, und einen Widerstand (161; 312, 322, 332, 342) umfasst, der zwischen den dritten Anschluss und die Verbindung zwischen dem Kondensator und den Mischmitteln geschaltet ist.

5. Mischer nach Anspruch 1, **dadurch gekennzeichnet, dass** in der Aufwärtsumformungsalternative
das zweite Signal am ersten Anschluss (120) bereitgestellt wird; und
das erste Signal als Eingabe am dritten Anschluss (140) bereitgestellt wird.

6. Mischer nach einem der vorhergehenden Ansprüche, **dadurch gekennzeichnet, dass** das Mischmittel ein spannungsgesteuerter Schalter ist.

7. Mischer nach einem der vorhergehenden Ansprüche, **dadurch gekennzeichnet, dass** das Mischmittel einen FET-Transformator-Schalter (111; 310, 320, 330, 340) umfasst, der entweder seinen Drain oder seine Source betrieblich mit dem ersten Anschluss verbunden, sein Gate betrieblich mit dem zweiten Anschluss verbunden und entweder seine Quelle oder seinen Drain betrieblich mit dem dritten Anschluss verbunden aufweist.

8. Mischer nach Anspruch 7, **dadurch gekennzeichnet, dass** der FET-Transistor ein NMOS-Transistor ist.

9. Mischer nach einem der vorhergehenden Ansprüche, **dadurch gekennzeichnet, dass** der Mischer ein symmetrischer Mischer ist, der eine gerade Anzahl von Mischmitteln umfasst.

10. Verwendung des Mischers nach einem der Ansprüche 1 bis 9 in einem elektronischen Gerät (1, 30).

11. Verwendung nach Anspruch 10, wobei das elektronische Gerät ein tragbares Kommunikationsgerät (1, 30) mit einer Versorgungsspannung von weniger als 2 V ist.

12. Verwendung nach Anspruch 10 oder 11, wobei das elektronische Gerät ein Mobilfunkendgerät, ein Mobiltelefon (1), ein Pager oder ein Communicator ist.

13. Verwendung nach Anspruch 10, wobei das elektronische Gerät so ausgelegt ist, dass es in einem drahtlosen lokalen Netz funktioniert.

14. Verwendung nach Anspruch 10 oder 11, wobei der Mischer in einem Kommunikationsgerät (30) verwendet wird, das so ausgelegt ist, dass es ergänzende Nahbereichskommunikation gemäß der Bluetooth®-Technologie bereitstellt.

15. Vorrichtung, umfassend den Mischer (300) nach einem der Ansprüche 1 bis 9, wobei der Mischer mit einem rauscharmen Verstärker (LNA) (400) verbunden ist, umfassend:
einen ersten Eingangsanschluss (401), der mit einem ersten Kondensator (410) verbunden ist, der mit einem ersten Verstärkungsmittel (411) verbunden ist, wobei das erste Verstärkungsmittel mit einem ersten Ausgangsanschluss (430) und mit einer Spannungsquelle über eine erste Induktionsspule (412) verbunden ist;
einen zweiten Eingangsanschluss (402), der mit einem zweiten Kondensator (420) verbunden ist, der mit einem zweiten Verstärkungsmittel (421) verbunden ist, wobei das zweite Verstärkungsmittel mit einem zweiten Ausgangsanschluss (431) und mit einer Spannungsquelle über eine zweite Induktionsspule (422) verbunden ist; und
wobei die ersten und zweiten Verstärkungsmittel (411, 421) Erdungsmittel ansteuern, und die ersten und zweiten Ausgangsanschlüsse (430, 431) über dritte und vierte Induktionsspulen (432, 433) die Erdungsmittel ansteuern.

## Revendications

1. Mélangeur passif (100 ;300) pour convertir un premier signal ayant une première fréquence en un second signal ayant une seconde fréquence, comprenant :
un moyen de mélange (110 ; 310,320,330,340), une première borne (120), une seconde borne (130) et une troisième borne (140), pour fournir le second signal en mélangeant un troisième signal ayant une troisième fréquence fourni comme entrée au niveau de ladite seconde borne, le premier signal étant fourni comme entrée au niveau soit de la première, soit de la troisième borne ; dans lequel :
la première borne (120) est connectée à une première borne de moyen de mélange du moyen de mélange (110) ;
la seconde borne (130) est connectée opérationnellement à une seconde borne de moyen de mélange du moyen de mélange ;
la troisième borne (140) est connectée opérationnellement à une troisième borne de moyen de mélange du moyen de mélange ; et par
un filtre passe-bas (160) connecté opérationnellement à ladite troisième borne (140) à une extrémité et à ladite seconde borne (130) à une autre extrémité de celui-ci, de telle sorte que
dans une variante de conversion à la baisse, le premier signal est fourni comme entrée à la première borne (120) et le second signal est fourni comme sortie de la troisième borne (140) ; et
dans une variante de conversion à la hausse, le premier signal est fourni comme entrée à la troisième borne (140) et le second signal est fourni comme sortie de la première borne (120).

2. Mélangeur selon la revendication 1, **caractérisé en ce que**, dans la variante de conversion à la baisse,
le second signal est fourni au niveau de la troisième borne (140) ;
le premier signal est fourni comme entée au niveau de la première borne (120) ; et
le filtre passe-bas (160) est compris dans un circuit de rétroaction (150 ; 311,321,331,341) connecté opérationnellement à ladite troisième (140) et ladite seconde borne (130).

3. Mélangeur selon la revendication 2, **caractérisé en ce que** le circuit de rétroaction (150 ;311,321,331,341) est un circuit d'amorçage.

4. Mélangeur selon une quelconque des revendications précédentes, **caractérisé en ce que** le filtre (160) comprend un condensateur (162,313,323,333,343) connecté entre ladite seconde borne et ledit moyen de mélange, et une résistance (161 ;312,322,332,342) connectée entre ladite troisième borne et la connexion entre ledit condensateur et ledit moyen de mélange.

5. Mélangeur selon la revendication 1, **caractérisé en ce que**, dans la variante de conversion à la hausse,
le second signal est fourni au niveau de la première borne (120) ; et
le premier signal est fourni comme entrée au niveau de la troisième borne (140).

6. Mélangeur selon une quelconque des revendications précédentes, **caractérisé en ce que** ledit moyen de mélange est un commutateur à tension commandée.

7. Mélangeur selon une quelconque des revendications précédentes, **caractérisé en ce que** ledit moyen de mélange comprend une commutateur à transistor FET (111 ; 310,320,330,340) ayant soit son drain, soit sa source connecté opérationnellement à ladite première borne, sa grille connectée opérationnelle à ladite seconde borne, et soit sa source, soit son drain connecté opérationnellement à ladite troisième borne.

8. Mélangeur selon la revendication 7, **caractérisé en ce que** ledit transistor FET est un transistor NMOS.

9. Mélangeur selon une quelconque des revendications précédentes, **caractérisé en ce que** le mélangeur est un mélangeur équilibré comprenant un nombre pair de moyens de mélange.

10. Utilisation du mélangeur selon une quelconque des revendications 1 à 9 dans un équipement électronique (1,30).

11. Utilisation selon la revendication 10, dans laquelle l'équipement électronique est un équipement de communication portable (1,30) ayant une tension d'alimentation inférieure à 2V.

12. Utilisation selon la revendication 10 ou 11, dans laquelle l'équipement électronique est un terminal radio mobile, un téléphone mobile, un pageur (1) ou un terminal de poche.

13. Utilisation selon la revendication 10, dans lequel l'équipement électronique est adapté pour fonctionner dans un réseau local sans fil.

14. Utilisation selon la revendication 10 ou 11, dans lequel le mélangeur est utilisé dans un équipement de communication (30) adapté pour fournir une communication supplémentaire à courte portée selon la technologie Bluetooth®.

15. Appareil comprenant le mélangeur (300) selon une quelconque des revendications 1 à 9, ledit mélangeur est connecté à un amplificateur de faible bruit (LNA) (400) comprenant :
une première borne d'entrée (401) connectée à un premier condensateur (410) étant connecté à un premier moyen d'amplification (411), ledit premier moyen d'amplification est connecté à une première borne de sortie (430) et à une alimentation en tension via un premier inducteur (412) ;
une seconde borne d'entrée (402) connectée à un second condensateur (420) étant connecté à un second moyen d'amplification (421), ledit second moyen d'amplification est connecté à une seconde borne de sortie (431) et à une alimentation en tension via un second inducteur (422) ; et
dans lequel le premier et le second moyen d'amplification (411,421) sont référencés à un moyen de mise à la masse, et la première et la seconde bornes de sortie (430,431) sont référencées audit moyen de mise à la masse via un troisième et un quatrième inducteur (432,433).
